Europäisches Patentamt

European Patent Office

Office européen des brevets

(19)

(11) Veröffentlichungsnummer: **0 182 088**
**B1**

(12) **EUROPÄISCHE PATENTSCHRIFT**

(45) Veröffentlichungstag der Patentschrift:
21.03.90

(51) Int. Cl.⁴: **H01L 29/91**

(21) Anmeldenummer: **85113023.7**

(22) Anmeldetag: **14.10.85**

(54) Schottky-Kontakt auf einer Halbleiteroberfläche und Verfahren zu dessen Herstellung.

(30) Priorität: **26.10.84 DE 3439315**

(43) Veröffentlichungstag der Anmeldung:
**28.05.86 Patentblatt 86/22**

(45) Bekanntmachung des Hinweises auf die Patenterteilung:
**21.03.90 Patentblatt 90/12**

(84) Benannte Vertragsstaaten:
**DE FR GB**

(56) Entgegenhaltungen:
**EP-A- 0 065 133**
**US-A- 3 961 350**
**US-A- 4 119 446**

**Die Akte enthält technische Angaben, die nach dem Eingang der Anmeldung eingereicht wurden und die nicht in dieser Patentschrift enthalten sind.**

(73) Patentinhaber: **Siemens Aktiengesellschaft, Wittelsbacherplatz 2, D-8000 München 2(DE)**

(72) Erfinder: **Losehand, Reinhard, Dipl.-Phys., Hofenfelsstrasse 13, D-8000 München 19(DE)**
Erfinder: **Eger, Helmut, Dipl.-Phys., Donaustrasse 11, D-8037 Olching(DE)**

**Beschreibung**

Die Erfindung betrifft einen Schottky-Kontakt auf einer Halbleiteroberfläche und ein Verfahren zu dessen Herstellung.

Im folgenden soll unter Schutzringbreite die Differenz zwischen dem Radius der äußeren Schutzringbegrenzung und dem Radius der inneren Schutzringbegrenzung verstanden werden.

Bei der Herstellung von Schottky-Kontakten für Hochfrequenzanwendungen ist man im allgemeinen bestrebt, parasitäre Kapazitäten des Schutzringes möglichst klein zu halten. Das läßt sich unter anderem durch eine geringe Schutzringbreite erreichen. Diese Forderung kann durch selbstjustierende Maßnahmen bei der Schutzringerzeugung verwirklicht werden.

Aus der deutschen Offenlegungsschrift 3 124 572 ist ein Verfahren zur Herstellung von Schottky-Dioden mit selbstjustierend angebrachtem Schutzring bekannt. Nach diesem Verfahren können Schutzringbreiten, die kleiner oder gleich ein Mikrometer sind, erzielt werden. Bei diesem bekannten Verfahren werden Hochtemperaturschritte vor der Anbringung des Schottky-Kontaktes ausgeführt. Weil sich das bekannte Verfahren nicht zur Herstellung von Schottky-Kontakten eignet, können die schließlich angebrachten Schottky-Kontakte nicht weiteren, nach erfolgter Schottky-Metallisierung eventuell nötigen Hochtemperaturprozessen ausgesetzt werden.

Das in der genannten deutschen Offenlegungsschrift 3124572 beschriebene Verfahren ist auch in der US-Anmeldung mit dem Aktenzeichen 383266 enthalten.

Häufig sollen Hochfrequenz-Schottky-Dioden nach Anbringen der Schottky-Metallisierung Hochtemperaturprozessen ausgesetzt werden.

Es kann ein Einbau von Schottky-Dioden in ein Gehäuse vorgesehen sein, wodurch derartige Dioden Einbautemperaturen bis zu 620 °C unterworfen werden. Wenn beispielsweise in ein solches Gehäuse zwei Schottky-Dioden hintereinander eingebaut werden und wenn dabei die beiden Schottky-Dioden unterschiedlichen Einbautemperaturen ausgesetzt sind, weisen die beiden Schottky-Dioden, sofern sie nach dem Stand der Technik hergestellt worden sind, in der Regel unterschiedliche Parameter auf. Wenn solche Gehäuse, in die zwei Schottky-Dioden eingebaut worden sind, beispielsweise in Mischern verwendet werden, müssen die beiden Schottky-Dioden, die jeweils in ein solches Gehäuse eingebaut worden sind, auch nach dem Einbau in dieses Gehäuse völlig gleiche Parameter aufweisen.

Auch zur Erzielung von High-Rel-Qualität ist eine Voralterung eines Schottky-Kontaktes bei hohen Temperaturen von 500 °C zweckmäßig.

Eine Temperung zwischen 400 °C und 700 °C ist bei den in bekannter Weise hergestellten Schottky-Kontakten deshalb nicht möglich, weil bei diesen Temperaturen Alkaliverunreinigungen aus dem Kontaktmetall in die Isolatorschicht der Dioden wandern, wodurch die Durchbruchspannung derartiger Dioden herabgesetzt wird.

Man hat bereits versucht, diesen Mangel durch eine Beschichtung aller Kanten des Isolatormaterials der Schottky-Dioden mit Siliciumnitrid, durch eine sogenannte Kantenversiegelung, zu beheben. Zum Öffnen der Siliciumnitrid-Versiegelung im Schutzringbereich ist jedoch eine weitere Fototechnik nötig, was wiederum eine Vergrößerung der Schutzringbreite zur Folge hat, weil bei einem solchen bekannten Verfahren, bei dem zweimal justiert wird, die Schutzringbreite mindestens doppelt so groß wie die größte Justiertoleranz sein muß.

Eine derartige Kantenversiegelung verhindert zwar das Eindringen von Alkaliverunreinigungen in die Isolatorschicht von Schottky-Dioden bei den vorgesehenen Temperungen, schafft dafür aber zu große parasitäre Kapazitäten des Schutzringes, die - wie anfangs erwähnt - für Hochfrequenzdioden nicht tragbar sind.

Der in der genannten deutschen Offenlegungsschrift 3124572 beschriebene Prozeß, der bisher für die Herstellung von Höchstfrequenzdioden mit selbstjustiertem Schutzring verwendet wird, liefert schlechte Ausbeuten. Beim bekannten Herstellungsprozeß erfolgt die Schottky- Metallisierung justierend, was bei der Herstellung von sehr vielen Schottky-Kontakten bei einem großen Teil dieser Schottky-Kontakte zu Asymmetrien im Aufbau dieser Schottky-Kontakte und damit zu relativ ungünstigen elektrischen Eigenschaften und damit zu einer schlechten Ausbeute im statistischen Durchschnitt führt.

Dieser Effekt wird bei Schottky-Metallisierungen, die zur Silicidbildung neigen, verstärkt. Da bei einem Schottky- Kontakt nach dem Stand der Technik der Schutzringbereich üblicherweise nicht abgedeckt ist, kann der Abstand zwischen der Oxidkante und dem effektiven Außenrand der Schutzringimplantation bei der Silicidbildung leicht überbrückt werden.

Da bei einem Schottky-Kontakt mit selbstjustiertem Schutzring nach dem Stand der Technik der Schutzringbereich praktisch nicht abgedeckt ist, sind bei einem solchen Schottky-Kontakt auch Nachbehandlungen wie z.B. Sputteretching, chemisches Ätzen, thermische Oxidation usw. nur sehr beschränkt möglich, weil auch bei diesen Nachbehandlungen der Abstand zwischen Oxidkante und effektivem Außenrand der Schutzringimplantation leicht überbrückt werden kann.

Der Oberbegriff des Anspruchs 1 geht aus von EP-A 0 065 133. Bei EP-A 0 065 133 ist die Poly-Silicium-Schicht 5 keine Passivierungsschicht. Außerdem bedeckt die Poly-Silicium-Schicht 5 nicht die dielektrische Schicht 3.

Bei US-A 4 119 446 werden zwei Justierschritte zur Herstellung eines Bauelements nach FIG 2c benötigt. Der Fotolack 6 wird mittels eines eigenen Justierschrittes strukturiert. Die äußere Umrandung des Schutzrings 4 ist daher nicht selbstjustiert bezüglich der inneren Umrandung des Schutzrings 4.

Der vorliegenden Erfindung liegt daher die Aufgabe zugrunde, einen Schottky-Kontakt nach dem Oberbegriff des Anspruchs 1 und ein Verfahren zur Herstellung eines solchen Schottky-Kontaktes anzugeben, mit denen eine Verbesserung der elektrischen Eigenschaften, insbesondere der Langzeitstabilität, eines Schottky-Kontaktes und eine Verbesserung der Ausbeute bei der Produktion eines Schottky-Kontaktes erzielt werden kann und mit denen eine Hochtemperaturbehandlung des Schottky-Kontaktes möglich ist.

Diese Aufgabe wird erfindungsgemäß durch einen Schottky-Kontakt nach den Ansprüchen 1, 8 und durch ein Verfahren nach den Ansprüchen 14, 16, 21 gelöst.

Eine mit einem justierenden Verfahren hergestellte Struktur ist bei gleichem Herstellungsaufwand immer um einen Faktor 2 schlechter ausgeführt als dieselbe mit einem selbstjustierenden Verfahren hergestellte Struktur. Die Herstellung einer Struktur mit einem justierenden Verfahren ist bei einem sehr viel höheren Aufwand als bei einem selbstjustierenden Verfahren zwar mit der gleichen Güte bei der Herstellung eines einzelnen Schottky-Kontaktes möglich, dafür muß in diesem Fall aber eine entsprechend schlechtere Ausbeute im statistischen Durchschnitt in Kauf genommen werden, die dann trotz des höheren Aufwandes bei der justierenden Herstellung etwa um den Faktor 10 schlechter ist als bei einer selbstjustierenden Herstellung derselben Struktur. Schottky-Dioden mit selbstjustierenden Schutzschichten lassen sich dadurch identifizieren, daß im statistischen Durchschnitt eine selbstjustierende Schutzschicht weit geringere räumliche Asymmetrien aufweist als eine justierend hergestellte Schutzschicht.

Wenn die selbstjustierend hergestellte Schutzschicht für den Schutzring eine Nitridschicht aufweist, können sehr feine Strukturen beim Schottky-Kontakt und beim Schutzring erzielt werden.

Eine Nitridschicht kann in einer Ausgestaltung der Erfindung so aufgebracht werden, daß sie auch nach einer Hochtemperaturbehandlung die Isolatorschicht der Schottky- Diode hermetisch abschließt. Dabei schließt die Nitridschicht die Isolatorschicht der Schottky-Diode innen und außen auf Silicium ab. Eine solche hermetisch abschließende Nitridschicht verhindert, daß bei einer Temperung von außen Verunreinigungen in die Isolatorschicht der Schottky-Diode eindringen. Wenn eine solche Nitridschicht auch innen am Silicium hermetisch abschließt, kann ein Schottky-Kontakt mit einer solchen hermetisch abschließenden Nitridschicht bis 700 °C getempert werden, ohne daß Alkaliverunreinigungen oder sonstige Verunreinigungen aus der Schottky-Metallisierung in die Isolatorschicht der Schottky-Diode eindringen können.

Würde eine Nitridschicht innen am Silicium (Halbleiteroberfläche) nicht dicht abschließen, so würden bei einer Hochtemperaturbehandlung Verunreinigungen aus dem Schottky-Metall in die Isolatorschicht eindringen.

Die Grenzfläche zwischen dem Halbleiter und der Isolatorschicht der Schottky-Diode muß eine möglichst saubere Grenzfläche sein. Zu diesem Zweck ist der pn-Übergang der Schottky-Diode als Schutzring ausgebildet. Die Isolatorschicht der Schottky-Diode muß vor chemischen Verunreinigungen geschützt werden. Wenn irgendwelche chemischen Verunreinigungen in die Isolatorschicht der Schottky- Diode eindringen können, wird die Grenzfläche zwischen dem Halbleiter und der Isolatorschicht der Schottky-Diode schlecht, wodurch die elektrischen Eigenschaften der Schottky-Diode negativ beeinflußt werden.

Bei selbstjustierend hergestellten Strukturen treten weniger Kanten, Ecken, Löcher und Oxidspalte auf als bei justierend hergestellten Strukturen. Da solche Ecken, Kanten, Löcher und Oxidspalte die Diffusion von Verunreinigungen begünstigen, ist ein Schottky-Kontakt mit einer selbstjustierend hergestellten Schutzschicht für den Schutzring besonders vorteilhaft.

Eine Schutzschicht für den Schutzring kann vorteilhafterweise mittels reaktivem Ionenätzen erzeugt werden.

Erfolgt die Dotierung des Schutzringes durch Implantation, so kann vorteilhafterweise ein Streuoxid auf der Halbleiteroberfläche, nämlich dort, wo der Schutzring entstehen soll, aufgebracht werden. Ein solches Streuoxid hält Verunreinigungen bei der Implantation zurück. Diese Verunreinigungen können anschließend zusammen mit dem Streuoxid entfernt werden. Das Streuoxid hilft, Verunreinigungen (Kontaminationen) zu vermeiden. Ein solches Streuoxid kann auch dazu verwendet werden, bei einem im Verlauf des Herstellungsverfahrens notwendigen Ätzvorgang ein Anätzen des Halbleiters der Schottky-Diode zu vermeiden.

Eine Nitridschicht kann vorteilhafterweise eine Hochtemperaturnitridschicht mit einer Dicke von 0,1 μm sein. Eine Nitridschicht kann auch eine Plasmanitridschicht mit einer Dicke von 0,5 μm bis 2 μm sein. Eine Plasmanitridschicht besitzt den Vorteil, daß sie bei tieferer Temperatur als eine Hochtemperaturnitridschicht aufgebracht werden kann. Bei Aufbringen einer Hochtemperaturnitridschicht auf eine Siliciumdioxidschicht bleibt beispielsweise Wasserstoff, der vorher mühsam bei 400 °C in die Siliumdioxidschicht eingebracht worden ist, nicht in der Siliciumdioxidschicht drin. Bei Aufbringen einer Plasmanitridschicht auf die Siliciumdioxidschicht bleibt dieser Wasserstoff in der Siliciumdioxidschicht drin und kann nach Aufbringen der Plasmanitridschicht nicht mehr aus der Siliciumdioxidschicht entweichen. Das Anbringen des Schottky-Metalls in einer selbstjustierten Vertiefung hat den Vorteil, daß der Serienwiderstand zwischen dem Schottky-Kontakt und der Rückseite des Halbleiters verkleinert ist.

Die Erfindung läßt sich vorteilhafterweise bei Schottky- Dioden mit selbstjustiertem Schutzring sowohl bei der Herstellung von Silicid-Dioden als auch bei der Anwendung einer Grabenätzstruktur verwenden. Sowohl bei der Herstellung von Silicid-Dioden als auch bei der Anwendung einer Grabenätzstruktur hilft die Erfindung, einen Kurzschluß zu vermeiden.

Bei Verwendung einer Nitrid-Oxid-Doppelschicht ist eine definierte Breite des Schutzringes auch bei Silicidbildung und bei einer Graben-Ätzbehandlung möglich. Die Verwendung einer Nitrid-Oxid-Doppelschicht als Ätzmaske ist besonders vorteilhaft bei Vorliegen einer Epitaxieschichtdicke von etwa 0,1 μm, wie sie bei Hochfrequenz- Schottky-Dioden vorkommt.

Die Verwendung einer Nitridschicht ermöglicht eine Schutzringbreite von 0,1 µm. Bei Mikrowellendioden stört eine Nitridschicht nicht. Bei größeren Schutzringbreiten kann auf eine Nitridschicht verzichtet werden. Bei hochsperrenden Dioden stört eine Nitridschicht.

Eine Nitridschicht kann vorteilhafterweise beim selektiven Naßätzen als Maskierung verwendet werden. Zur Ätzmaskierung bei einer Plasmaätzung kann vorteilhafterweise eine Oxidschicht verwendet werden.

Da bei Verwendung einer Fototechnik die zu erzeugende Struktur bei den üblichen Fototechnik-Verfahren nur auf etwa 10 % genau erzeugt wird, kann eine Struktur nach der Erfindung wesentlich genauer als nach dem Stand der Technik erzeugt werden.

Wesentlich bei der Erfindung ist, daß die Außenkante des Schutzringes von einer selbstjustierend auf den Schutzring aufgebrachten Schutzschicht sicher abgedeckt ist. Damit wird bei der Herstellung des Schottky-Kontaktes bereits eine hohe Ausbeute erzielt. Damit lassen sich die bei einer Schottky-Diode geforderten elektrischen und sonstigen Parameter auch bei einer Hochtemperaturbehandlung nach Anbringen des Schottky-Kontaktes genauer einhalten. Damit lassen sich auch Strukturparameter beispielsweise beim Schutzring oder beim Schottky-Kontakt genauer einhalten. Bei einem nach der Erfindung hergestellten Schottky-Kontakt ist außerdem die Gefahr von Schutzringschwachstellen infolge von rauher Maskiermetallisierung geringer. Dadurch sind effektive Schutzringbreiten kleiner als 0,2 µm leichter zu realisieren. Die Verwendung eines Streuoxides ermöglicht eine höhere Implantationsenergie auch dann, wenn der zu implantierende Stoff verunreinigt ist. Dadurch kann auch bei verunreinigtem Implantationsstoff die Struktur des Schutzringes genauer hergestellt werden.

Die Erfindung wird im folgenden anhand der Zeichnung und mittels Ausführungsbeispielen näher beschrieben.

Fig. 1 bis 5 stellen Verfahrensschritte zur Herstellung eines Schotty-Kontaktes nach dem Stand der Technik dar.

Fig. 6 bis 10 stellen Verfahrensschritte zur Herstellung eines Schottky-Kontaktes nach einem ersten Ausführungsbeispiel der Erfindung dar.

Fig. 11 bis 19 stellen Verfahrensschritte zur Herstellung eines Schottky-Kontaktes nach einem zweiten Ausführungsbeispiel der Erfindung dar.

Fig. 20 bis 24 stellen Verfahrensschritte zur Herstellung eines Schottky-Kontaktes nach einem dritten Ausführungsbeispiel der Erfindung dar.

Fig. 25 bis 29 stellen Verfahrensschritte zur Herstellung eines Schottky-Kontaktes nach einem vierten Ausführungsbeispiel der Erfindung dar.

Fig. 30 stellt das Ergebnis eines fünften Ausführungsbeispiels für ein Verfahren nach der Erfindung dar.

In den folgenden Figuren werden gleiche Gegenstände mit gleichen Bezugszeichen belegt.

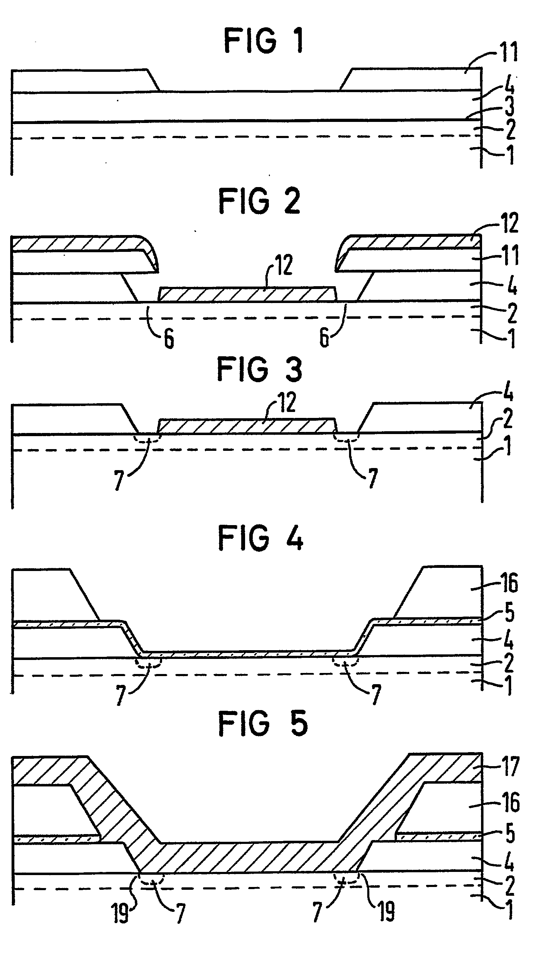

Fig. 1 zeigt ein Substrat 1, das z. B. aus Silicium bestehen kann und z. B. p+-dotiert oder n+-dotiert sein kann. Das Substrat 1 kann jedoch auch aus einem anderen Material, z. B. aus Galliumarsenid (GaAs), Indiumphosphid (InP) oder aus Germanium (Ge) bestehen. Es sind auch andere Substratdotierungen als die angegebenen Substratdotierungen möglich. Auf dem Substrat 1 ist eine z. B. epitaktisch abgeschiedene Halbleiterschicht 2 angebracht, die bei n+-dotiertem Substrat n-dotiert ist und bei p+-dotiertem Substrat p-dotiert ist und die vorzugsweise aus Silicium besteht. Die Halbleiterschicht 2 kann jedoch auch aus einem anderen Halbleitermaterial bestehen, z. B. aus Galliumarsenid, Indiumphosphid oder Germanium. Die Halbleiterschicht 2 kann auch je nach verwendetem Substrat 1 und je nach Anwendungsbereich eine andere Dotierung aufweisen. Auf der Oberfläche 3 der Halbleiterschicht 2 ist eine erste Schicht 4 aus elektrisch isolierendem Material aufgebracht. Teile der ersten Schicht 4 werden nach ihrer Strukturierung die Isolatorschicht der Schottky-Diode bilden. Das Material der ersten Schicht 4 muß gegenüber einem elektrisch isolierendem Material, das später als zweite Schicht 5 aufgebracht werden wird, selektiv ätzbar sein. Die erste Schicht 4 wird beim Stand der Technik mit Hilfe eines Fotoresist 11 mittels Fototechnik so strukturiert, daß die erste Schicht 4 im Schutzringbereich 6 ganz entfernt wird.

Fig. 2 zeigt ein Halbleiterplättchen nach Fig. 1, bei dem Teile der ersten Schicht 4 im Schutzringbereich 6 weggeätzt worden sind und das danach mit einem Metall 12 beschichtet worden ist. Wenn die erste Schicht 4 aus Siliciumdioxid besteht, kann zum Wegätzen von Siliciumdioxid eine 10%ige Flußsäure (HF) verwendet werden. Bei diesem Ätzvorgang wird ein Unterätzen unter der Kante des Fotoresist 11 zugelassen. Die Dauer des Unterätzens definiert die spätere Schutzringbreite.

Fig. 3 zeigt ein Halbleiterplättchen nach Fig. 2, bei dem das Fotoresist 11 abgehoben worden ist und bei dem der Schutzringbereich 6 beispielsweise mittels Implantation oder mittels Diffusion dotiert worden ist, so daß im Schutzringbereich 6 der Schutzring 7 entstanden ist.

Fig. 4 zeigt ein Halbleiterplättchen nach Fig. 3, bei dem das Metall 12 abgelöst worden ist, das sodann mit einer zweiten Schicht 5 überzogen worden ist, auf das sodann eine weitere Oxidschicht 16 aufgebracht worden ist und bei dem schließlich die weitere Oxidschicht 16 mittels Fototechnik strukturiert worden ist. Die zweite Schicht 5 kann beispielsweise eine Siliciumnitridschicht sein, die weitere Schicht 16 kann beispielsweise eine Siliciumdioxidschicht sein.

Fig. 5 zeigt ein Halbleiterplättchen nach Fig. 4, bei dem Teile der zweiten Schicht 5 weggeätzt worden sind, und auf das schließlich ein Schottky-Metall 17 aufgebracht worden ist. Wenn die zweite Schicht 5 aus Siliciumnitrid besteht, können Teile dieser zweiten Schicht 5 durch eine Naßätzung mit Phosphorsäure ($H_3PO_4$) entfernt werden.

Ein Halbleiterplättchen nach Fig. 5 besitzt kritische Stellen 19, da der Abstand zwischen der Kante der ersten Schicht 4 und dem effektiven Außenrand des Schutzringes 7 bei einem Schottky-Kontakt nach dem Stand der Technik unter Umständen leicht überbrückt werden kann. Dies führt sehr leicht zu Kurzschlüssen und somit zu einer geringen Ausbeute bei einem Schottky-Kontakt, der nach dem Stand der Technik hergestellt wird. Bei Herstellung von Schottky-Silicid-Dioden wird der Siliciumanteil sowohl beim Schutzring 7 als auch im Inneren des Schutzringes 7 kleiner. Dadurch wird die Gefahr von Kurzschlüssen verstärkt. Auch bei der Anwendung von Graben("moat")-ätzen werden Teile sowohl des Schutzringes 7 als auch des im Inneren des Schutzringes 7 gelegenen Siliciums entfernt. Auch dadurch wird die Gefahr von Kurzschlüssen erhöht. Selbst wenn der Schutzring 7 von einer Schutzschicht überdeckt sein würde, die nicht selbstjustierend aufgebracht worden ist und somit ungenaue Strukturen aufweist, ist bei Herstellung von Schottky-Silicid-Dioden oder bei Anwendung einer Grabenätztechnik die Gefahr von Kurzschlüssen groß und ist generell auch ohne Anwendung von besonderen zusätzlichen Techniken die Ausbeute gering.

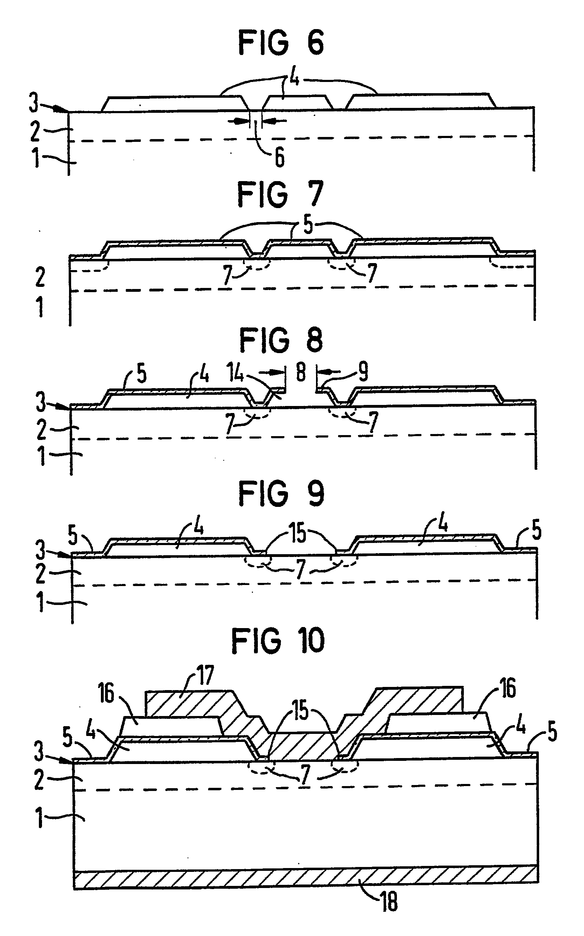

Fig. 6 bis 10 erläutern ein Verfahren eines Schottky-Kontaktes nach einem ersten Ausführungsbeispiel der Erfindung. Auf die Oberfläche 3 der Halbleiterschicht 2 ist eine erste Schicht 4 aus elektrisch isolierendem Material aufgebracht. Die erste Schicht 4 wird z. B. mittels Fototechnik oder mittels reaktivem Ionenätzen so strukturiert, daß diese erste Schicht im Schutzringbereich 6 ganz oder, zur Erzeugung eines Streuoxides für eine spätere Dotierung des Schutzringbereiches 6, bis auf eine geringe Schichtdicke von ungefähr 0,1 µm oder weniger entfernt wird. Bei der Verwendung von Silicium für die Halbleiterschicht 2 und bei der Verwendung von Siliciumdioxid für die erste Schicht 4 kann eine dünne Schicht aus Siliciumdioxid im Bereich der Schutzringoberfläche so hergestellt werden, daß in diesem Bereich die Siliciumdioxidschicht zunächst ganz entfernt wird und daß anschließend eine dünne Schicht mittels Oxidation wiederum aufgebracht wird. Danach kann eine Dotierung des Schutzringbereiches 6 z. B. mittels Implantation oder mittels Diffusion erfolgen. Danach wird eine eventuell vorhandene geringe Schichtdicke der ersten Schicht 4 im Schutzringbereich 6 vollkommen entfernt.

Fig. 7 zeigt ein Halbleiterplättchen nach Fig. 6, auf dem eine zweite Schicht 5 oberhalb der ersten Schicht ganzflächig abgeschieden ist. Die zweite Schicht 5 besteht aus elektrisch isolierendem und gegenüber der ersten Schicht 4 selektiv ätzbarem Material, das auch noch als Sperre gegenüber Alkaliverunreinigungen wirkt. Die zweite Schicht 5 kann eine so geringe Schichtdicke aufweisen, beispielsweise etwa 0,1 µm, daß eine Dotierung des Schutzringbereiches 6 durch diese zweite Schicht 5 hindurch möglich ist, falls die Dotierung des Schutzringbereiches 6 nicht bereits vor Aufbringen der zweiten Schicht 5 erfolgt ist. Die erste Schicht 4 kann aus Siliciumdioxid ($SiO_2$) und die zweite Schicht 5 kann aus Siliciumnitrid ($Si_3N_4$) bestehen.

Fig. 8 zeigt ein Halbleiterplättchen nach Fig. 7, das ein Fenster 8 in der zweiten Schicht 5 im Bereich oberhalb des anzubringenden Schottky-Kontaktes aufweist. Die Öffnungsfläche des Fensters 8 ist kleiner als die Fläche des vorgesehenen Schottky-Kontaktes. Das Fenster 8 kann beispielsweise mittels Fototechnik und mittels Plasmaätzen erzeugt werden. Durch das Fenster 8 wird selektiv der darunterliegende Teil 14 der ersten Schicht 4 vollständig weggeätzt. Die Ätzzeit muß dabei so bemessen sein, daß auch bei einer Dejustierung des Fensters 8 die laterale Unterätzung unterhalb der Krempen 9 ausreicht, um den darunterliegenden Teil 14 vollkommen wegzuätzen. Dies ist in der Regel leicht möglich, da die Selektivität der Ätzung gut ist. Nachfolgend werden die Krempen 9 weggeätzt. Da bei einer Naßätzung mit Phosphorsäure bei Verwendung von Siliciumnitrid als zweiter Schicht 5 die Phosphorsäure sowohl die Öffnung des entfernten Teils 14 ausfüllt, als auch die Krempen 9 von außen umspült, da die Phosphorsäure also die Krempen 9 beidseitig angreift, werden die Krempen 9 vollständig entfernt, während die Schichtdicke der restlichen zweiten Schicht 5 lediglich halbiert wird. Bei einer geeigneten Bemessung der Schichtdicken bleibt auf den restlichen Teilen der ersten Schicht 4 eine hinreichend dicke Schicht 5 zurück. Werden als erste Schicht 4 eine Siliciumdioxidschicht und als zweite Schicht 5 eine Siliciumnitridschicht verwendet, so empfiehlt es sich, die Siliciumdioxidschicht 0,1 µm bis 2 µm, insbesondere 1 µm, und die Siliciumnitridschicht 0,05 µm bis 1 µm, insbesondere 0,1 µm, dick zu halten.

Wenn auf der zweiten Schicht 5 und somit auf den Krempen 9 ein Fotolack oder eine Siliciumdioxid-Hilfsschicht vor dem Wegätzen der Krempen 9 angeordnet ist, werden beim Wegätzen der Krempen 9 die Krempen 9 nur von dorther von der Säure angegriffen, wo vorher der Teil 14 der ersten Schicht 4 angeordnet gewesen ist. Bei einem solchen Vorgehen können die Krempen 9 vollständig entfernt werden, ohne daß der Rest der zweiten Schicht 5 von der Säure angegriffen wird. Daher kann bei einem solchen Vorgehen der Rest der zweiten Schicht 5 seine ursprüngliche Dicke beibehalten. Nach dem Wegätzen der Krempen 9 muß dann nur die auf der zweiten Schicht 5 vorhandene Hilfsschicht (Fotolack bzw. Siliciumdioxid) entfernt werden.

Fig. 9 zeigt ein Halbleiterplättchen nach Fig. 8 nach Entfernung der Krempen 9. Der innere Rand 15 der zweiten Schicht 5 wird selbstjustierend bezüglich der Lage des Schutzringes 7 durch die Krempenätzung erzeugt.

Fig. 10 zeigt ein Halbleiterplättchen nach Fig. 9, das oberhalb der zweiten Schicht 5 mit einer zusätzlichen Isolatorschicht 16, einem Schottky-Kontakt 17 und einem Substratkontakt 18 versehen ist. Die Anbringung der Isolatorschicht 16 ist nicht zwingend, kann jedoch erfolgen, um z. B. parasitäre Kapazitäten zu verringern. Die Isolatorschicht 16 ist wichtig bei Dioden mit relativ kleinem Durchmesser von beispielsweise 10 µm. Die Isolatorschicht 16 kann beispielsweise aus Siliciumdioxid, aus Kunststoff (Polyimid) oder aus Glas bestehen. Die Isolatorschicht 16 ermöglicht es, daß der Durchmesser des Schottky-Kontaktes größer ist als der Durchmesser der Diode. Bei Dioden, die einen Durchmesser

von beispielsweise 80 µm haben, ist eine Isolatorschicht 16 nicht notwendig.

Als Schottky-Kontakt wird direkt auf der Halbleiteroberfläche 3 mindestens ein Schottky-Metall angebracht, das die Halbleiteroberfläche 3 bis zum inneren Rand 15 der zweiten Schicht 5 abdeckt und das auch die Isolatorschichten teilweise überlagern kann. Der Schottky-Kontakt 17 kann aus mindestens einem der Materialien Titan, Molybdän, Platin, Palladium oder Nickel bestehen. Zur Verstärkung können darüber und über Teile der Isolatorschichten weitere Metallschichten angebracht sein, z. B. eine Schichtenfolge aus Platin und Gold. Auf der Rückseite des Halbleiterplättchens befindet sich der Substratkontakt 18. Der Substratkontakt 18 kann jedoch auch vorderseitig angebracht werden, z. B. in Beam-Lead-Technik oder bei einer Flip-Chip-Ausführung der Schottky-Diode.

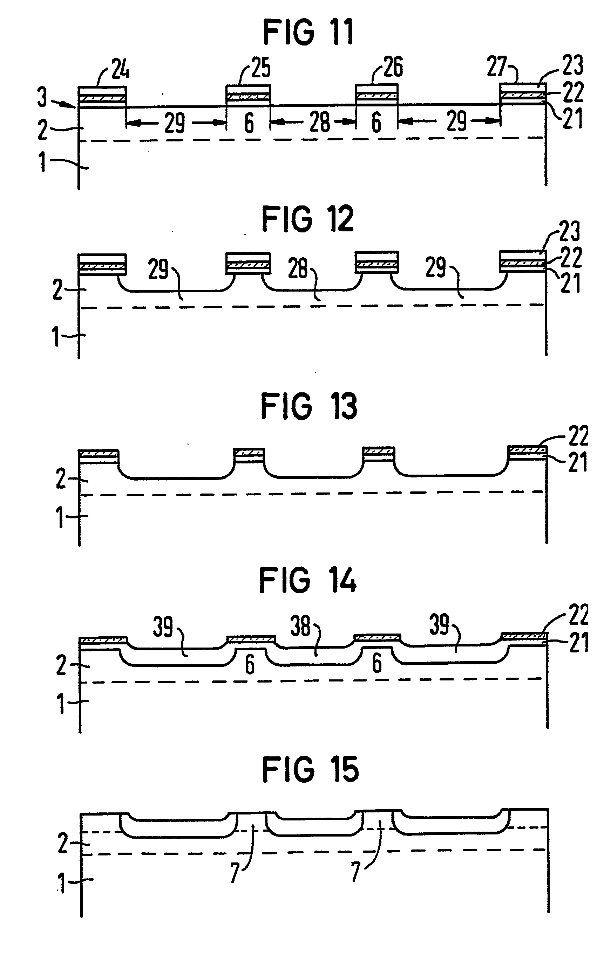

Die Fig. 11 bis 18 zeigen ein Verfahren zur Herstellung eines Schottky-Kontaktes nach einem zweiten Ausführungsbeispiel der Erfindung. Fig. 11 zeigt ein Halbleiterplättchen wie Fig. 6, jedoch ohne erste Schicht 4. Auf der Halbleiteroberfläche 3 werden ganzflächig übereinander zunächst eine Siliciumdioxidschicht 21 von z. B. ca. 0,1 µm Dicke, darüber ganzflächig eine Siliciumnitridschicht 22 mit einer Schichtdicke von z. B. ca. 0,1 µm und darüber wiederum eine Siliciumdioxidschicht 23 in einer Schichtstärke von z. B. ca. 0,2 µm abgeschieden. Durch eine Fototechnik und durch nachfolgende selektive Ätzung der einzelnen Schichten 21, 22, 23 wird der Schutzringbereich 6 durch die zurückgebliebenen Maskenteile 25 und 26 abgedeckt. Außerdem sind mit den Maskenteilen 24 und 27 die Rahmenteile eines zu bildenden Schottky-Kontaktes abgedeckt. Die Teilbereiche 28 und 29 der Halbleiteroberfläche 3 liegen hingegen frei.

Fig. 12 zeigt ein Halbleiterplättchen nach Fig. 11, bei dem Teile der Halbleiterschicht 2 innerhalb der Teilbereiche 28 und 29 mittels Plasmaätzen, reaktivem Ionenätzen oder mit Hilfe eines Ionenstrahles weggeätzt sind. Bei einer Siliciumplasmaätzung ist die Siliciumdioxidschicht 23 zur Ätzmaskierung erforderlich, da die Siliciumnitridschicht 22 bei einer Siliciumplasmaätzung nicht als Ätzmaskierung dienen kann.

Fig. 13 zeigt ein Halbleiterplättchen nach Fig. 12, bei dem die verbliebenen Teile der Siliciumdioxidschicht 23 z. B. mittels Flußsäure entfernt sind. Die Krempen der Maskenteile 24, 25, 26, 27, die bei einem Halbleiterplättchen nach Fig. 12 vorhanden sind, können beispielsweise dadurch entfernt werden, daß zuerst mit Flußsäure so lange geätzt wird, bis die Krempen der Siliciumdioxidschicht 21 entfernt sind, daß sodann mit Phosphorsäure geätzt wird, bis die Krempen der Siliciumnitridschicht 22 vollständig entfernt sind und daß schließlich mittels ganzflächiger Siliciumdioxid-Überätzung so lange naßgeätzt wird, bis die gesamte Siliciumdioxidschicht 23 entfernt ist.

Die verbliebenen Teile der Nitridschicht 22 dienen zur Maskierung der Rahmenteile des zu bildenden Schottky-Kontaktes und zur Maskierung des Schutzringbereiches 6 bei dem nachfolgenden selektiven Oxidationsprozeß.

Fig. 14 zeigt ein Halbleiterplättchen nach Fig. 13, bei dem in den Teilbereichen 28 und 29 Dickoxidschichten 38 und 39 erzeugt worden sind. Eine derartige Dickoxidbildung läßt sich beispielsweise durch thermische Oxidation in feuchter Sauerstoffatmosphäre bewirken. Eine solche selektive Oxidation läßt sich jedoch auch mittels Hochdruck oder in einem Plasma durchführen.

Fig. 15 zeigt ein Halbleiterplättchen nach Fig. 14, bei dem die verbliebenen Teile der Siliciumnitridschicht 22 z. B. mittels Phosphorsäure weggeätzt sind. Durch die im Schutzringbereich 6 verbliebene Siliciumdioxidschicht hindurch kann der Schutzringbereich 6 dotiert werden. Schließlich wird die gesamte Siliciumdioxidschicht des Halbleiterplättchens nach Fig. 14 ganzflächig mit Flußsäure überätzt. Diese Überätzung dauert so lange, bis Teile des Schutzringes 7 und bis Rahmenteile des zu bildenden Schottky-Kontaktes freiliegen.

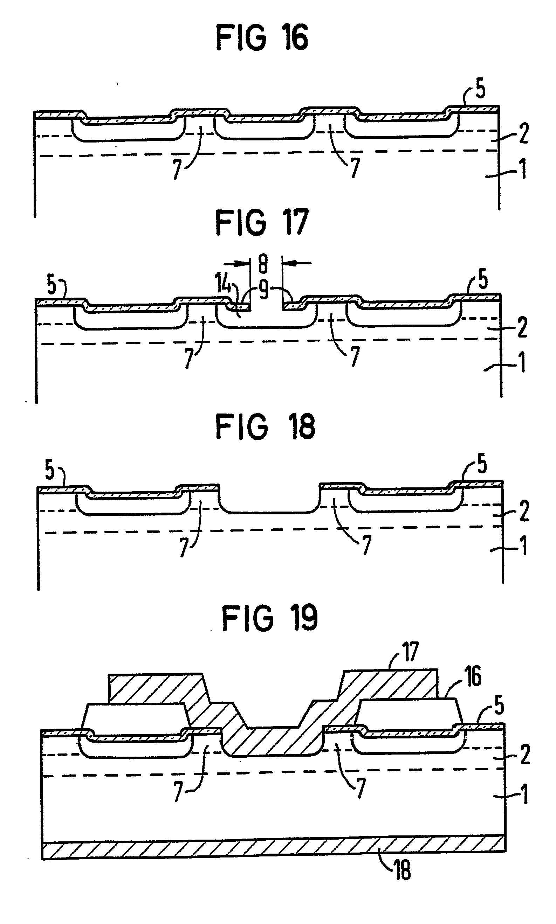

Fig. 16 zeigt ein Halbleiterplättchen nach Fig. 15, das mit einer Siliciumnitridschicht ganzflächig als zweite Schicht 5 beschichtet ist.

Fig. 17 zeigt ein Halbleiterplättchen nach Fig. 16, das mit einem Fenster 8 in der Siliciumnitridschicht 5 versehen ist. Durch das Fenster 8 wird der darunterliegende Teil 14 der Siliciumdioxidschicht in selektiver Weise so weggeätzt, wie das bei der Fig. 8 beschrieben ist. Anschließend werden die Nitridkrempen 9 weggeätzt, was ebenfalls bei Fig. 8 näher beschrieben ist.

Fig. 18 zeigt ein Halbleiterplättchen nach Fig. 17 nach erfolgter Wegätzung der Krempen 9. Die verbliebene restliche Nitridschicht 5 weist nach der Krempenätzung beispielsweise etwa die Hälfte ihrer anfänglichen Schichtdicke auf.

Fig. 19 zeigt ein Halbleiterplättchen nach Fig. 18, das ähnlich, wie in Fig. 10 beschrieben, mit einer zusätzlichen Isolatorschicht 16 versehen sein kann und einen Schottky-Kontakt 17 und einen Substratkontakt 18 aufweist. Ein Halbleiterplättchen nach Fig. 19 hat essentielle Vorteile: Der Schutzring 7 ist selbstjustiert, die Vertiefungen in den Bereichen 28 und 29 sind selbstjustiert und der Serienwiderstand zwischen dem Schottky-Kontakt und der Rückseite des Halbleiterplättchens, dort wo in Fig. 19 der Substratkontakt angebracht ist, wird infolge der Vertiefung im Bereich 28 kleiner. Mit einer Schottky-Diode nach Fig. 19 lassen sich auch Schutzringbreiten kleiner als 0,2 µm verwirklichen.

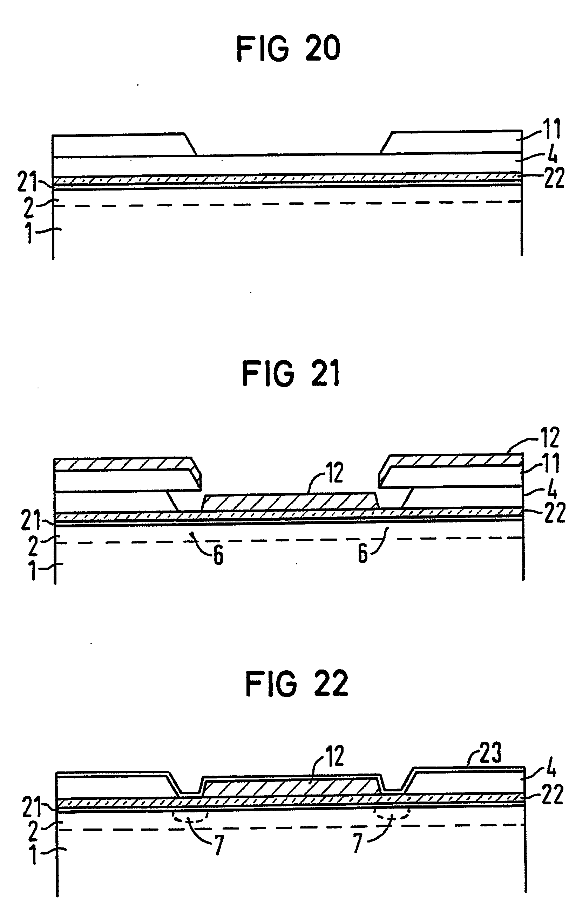

Fig. 20 bis 24 erläutern ein Verfahren nach einem dritten Ausführungsbeispiel der Erfindung. Dieser neue Prozeß erreicht durch Einfügen einer Oxid-Nitrid-Doppelschicht und durch eine zusätzliche Abhebetechnik, daß die Schutzringaußenkante sicher abgedeckt ist. Die Lage der Oxid-Nitrid-Passivierungskante relativ zur Innenkante des Schutzringes 7 kann in definierter Weise eingestellt werden.

Fig. 20 zeigt ein Halbleiterplättchen, bei dem auf die Halbleiteroberfläche zuerst eine Oxidschicht 21 und sodann eine Nitridschicht 22 aufgebracht sind. Die Oxid-Nitrid-Doppelschicht auf der Halbleiteroberfläche besteht also aus den beiden Schichten 21, 22. Auf diese Oxid-Nitrid-Doppelschicht ist in bekannter Weise eine Oxidschicht 4 aufgebracht, die beispielsweise mittels Fototechnik und vorteilhafterweise mittels reaktivem Ionenätzen strukturiert wird.

Fig. 21 zeigt ein Halbleiterplättchen nach Fig. 20, bei dem Teile der Oxidschicht 4 mittels Oxidätzen mit Unterätzung entfernt worden sind und das sodann mit einem Metall 12 beschichtet worden ist.

Fig. 22 zeigt ein Halbleiterplättchen nach Fig. 21, bei dem das Fotoresist 11 abgehoben worden ist, bei dem der Schutzringbereich 6 dotiert worden ist und bei dem eine weitere Oxidschicht 23 aufgebracht worden ist. Die weitere Oxidschicht 23 dient als Ätzvorhalt bei späteren Ätzvorgängen hinsichtlich der Oxid-Nitrid-Doppelschicht.

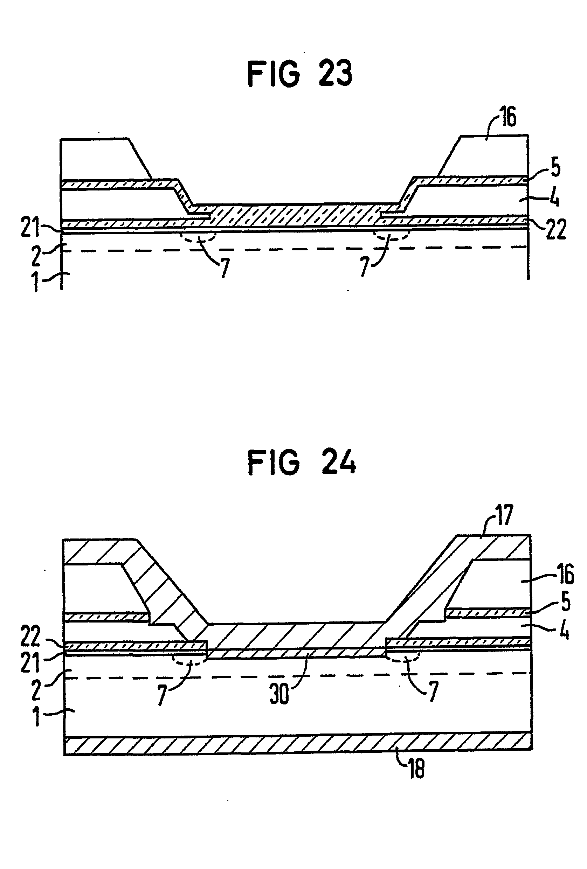

Fig. 23 zeigt ein Halbleiterplättchen nach Fig. 22, bei dem das Metall 12 abgehoben worden ist, bei dem eine Nitridschicht 5 aufgebracht worden ist, das mit einer weiteren Oxidschicht 16 überzogen worden ist, und bei dem die weitere Oxidschicht 16 beispielsweise mittels Fototechnik und mittels reaktiven Ionenätzen strukturiert worden ist. Das Abheben des innerhalb des Schutzringes 7 verbliebenen Metalles 12 kann dadurch erreicht werden, daß beispielsweise in das im Inneren des Schutzringes 7 gelegenen Maskenteil bedeckende Oxid 23 ein Fenster eröffnet wird und daß das darunterliegende Metall mit Säure durch das Fenster hindurch weggeätzt wird.

Fig. 24 zeigt ein Halbleiterplättchen nach Fig. 23, bei dem zuerst Teile der Nitridschicht 5 und Teile der Nitridschicht 22, soweit sie nicht durch die Oxidschicht 4 geschützt sind, mittels Phosphorsäure weggeätzt worden sind, bei dem sodann dünne Teile der Oxidschicht 4 mittels kurzer Überätzung mit Flußsäure weggeätzt worden sind, auf das sodann ein Schottky-Metall 17 aufgebracht worden ist, und bei dem schließlich eine Silicidschicht 30 gebildet worden ist.

Die Oxidschicht 23 wird in Fig. 22 als Streuoxid für die Dotierung des Schutzringbereiches 6 mittels Implantation verwendet. Wegen der nun möglichen höheren Implantationsenergie wird erreicht, daß die Gefahr von Schutzringschwachstellen infolge rauher Maskiermetallisierung geringer wird. Dadurch sind effektive Schutzringbreiten kleiner als 0,2 μm leichter zu realisieren.

Bei einem Halbleiterplättchen nach Fig. 24 ist eine Silicidbildung ohne Gefahr von Kurzschlüssen möglich.

Bei einem Halbleiterplättchen, das mit einem in den Fig. 20 bis 24 dargestellten Verfahren hergestellt worden ist, ist auch eine Grabenätzung erlaubt.

Die Zeitdauer des Unterätzens beim Ätzen der Oxidschicht 4 bestimmt den Abstand der Oxidkante der Oxidschicht 4 von der Innenkante des Schutzringes 7.

Hochfrequenz-Schottky-Dioden besitzen Epitaxieschichtdicken von etwa 0,1 μm. Andere Schottky-Dioden besitzen Epitaxieschichtdicken von etwa 2 μm. Wenn an diesen Epitaxieschichten eine Siliciumätzung vorgenommen werden soll, dient die Oxid-Nitrid-Doppelschicht als Ätzvorhalt. Diese Oxid-Nitrid-Doppelschicht ermöglicht eine definierte Breite des Schutzringes 7 auch bei einer Silicidbildung und auch bei einer Grabenätzung. Bei Silicidbildung und bei einer Grabenätzung bestimmt die Passivierungskante der Oxid-Nitrid-Doppelschicht die Innenkante des Schutzringes 7.

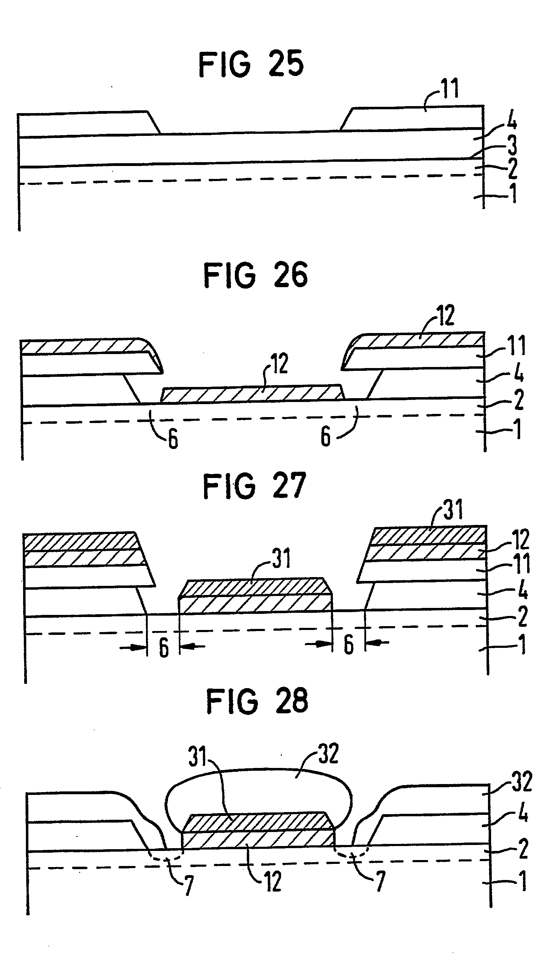

Fig. 25 stimmt mit der Fig. 1 überein. Fig. 26 stimmt mit der Fig. 2 überein. Die Verfahrensschritte zur Herstellung eines Halbleiterplättchens nach den Fig. 25 und 26 entsprechen den Verfahrensschritten zur Herstellung eines Halbleiterplättchens nach den Fig. 1 und 2.

Fig. 27 zeigt ein Halbleiterplättchen nach Fig. 26, bei dem auf die Metallschicht 12 eine weitere Metallschicht 31 aufgetragen worden ist. Die weitere Metallschicht 31 kann beispielsweise mit einer Punktquelle aufgedampft werden, so daß sich bei dem Metallstück, das im Inneren des Schutzringbereiches 6 liegt, steile Kanten bilden. Dieses Metallstück im Inneren des Schutzringbereiches 6 dient zur Maskierung für die spätere Dotierung des Schutzringes 7 mittels Implantation.

Fig. 28 zeigt ein Halbleiterplättchen nach Fig. 27, bei dem die Fotoresistschicht 11 abgetragen worden ist, bei dem durch Dotierung des Schutzringbereiches 6 der Schutzring 7 erzeugt worden ist und das mit einer Oxidschicht 32 beschichtet worden ist. Vor der Implantation kann im Schutzringbereich 6 eine dünne Streuoxidschicht aufgebracht werden, die dann nach der Implantation und vor Auftragen der Oxidschicht 32 wieder entfernt wird. Der Abstand der Passivierungskante der Oxidschicht 4 von der Passivierungskante der Oxidschicht 32 ist selbstjustiert. Die Oxidschicht 32 kann zumindest teilweise dick aufgetragen werden. Die Oxidschicht 32 bildet eine selbstjustierte Schutzschicht für den Schutzring 7. Die Oxidschicht 32 bildet eine Maskierung für das spätere Abheben des innerhalb des Schutzringes 7 verbliebenen Metalles 12. Die Passivierungskante der Oxidschicht 32 kann mit der Innenkante des Schutzringes 7 zusammenfallen. Die Passivierungskante der Oxidschicht 32 kann jedoch auch zwischen der Innenkante und der Außenkante des Schutzringes 7 liegen und einen definierten, selbstjustierten Abstand zur Innenkante des Schutzringes 7 aufweisen. Dieser Umstand, nämlich daß der Abstand der Passivierungskante der Oxidschicht 32 zur Innenkante des Schutzringes 7 in definierter Weise eingestellt werden kann, ist wichtig für eine Grabenätzung. Die Oxidschicht 32 wird bei einer solchen Grabenätzung nicht angegriffen.

Die definierte Einstellung des Abstandes der Passivierungskante der Oxidschicht 32 von der Innenkante des Schutzringes 7 kann beispielsweise durch unterschiedliches Auftragen der Oxidschicht 32, durch unterschiedliche Dicke der Oxidschicht 32 und durch unterschiedliche Kantenbildung bei der Aufdampfung des weiteren Metalles 31 erfolgen.

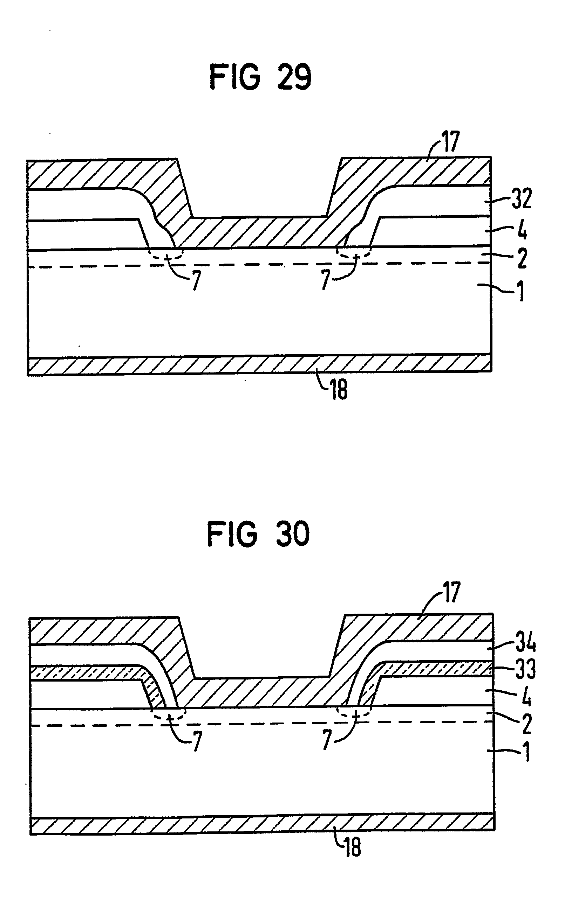

Fig. 29 zeigt ein Halbleiterplättchen nach Fig. 28, bei dem das innerhalb des Schutzringes 7 verbliebene Metall 12 abgehoben worden ist und bei dem schließlich das Schottky-Metall 17 aufgebracht worden ist. Bei einem Halbleiterplättchen nach Fig. 29 ist sowohl eine Silicidbildung als auch eine Grabenätzung erlaubt.

Das Abheben des innerhalb des Schutzringes 7 verbliebenen Metalles 12 kann dadurch erreicht werden, daß beispielsweise in das den im Inneren des Schutzringes 7 gelegenen Maskenteil bedeckende Oxid 32 ein Fenster eröffnet wird und daß das darunterliegende Metall mit Säure durch das Fenster hindurch weggeätzt wird. Wenn als Metall 12 Titan verwendet wird, ermöglicht Palladium, das als weiteres Metall 31 auf Titan aufgedampft worden ist, daß das darunterliegende Titan auch bei dickeren Oxidschichten 32 leicht abgehoben werden kann. Wenn die Oxidschicht 32 nicht so dick ist, kann auf das weitere Metall 31 verzichtet werden. Zum Wegätzen des Palladiums eignet sich Königswasser, zum Wegätzen des unter dem Palladium liegenden Titans eignet sich heiße Phosphorsäure.

Fig. 30 zeigt ein fünftes Ausführungsbeispiel für ein Halbleiterplättchen nach der Erfindung. Ein Halbleiterplättchen nach Fig. 30 kann völlig analog zu einem Halbleiterplättchen nach Fig. 29 hergestellt werden, falls anstelle der Oxidschicht 32 in Fig. 28 erst eine Nitridschicht 33 und sodann eine Oxidschicht 34 aufgebracht werden. Die Nitridschicht 33 kann beispielsweise aufgesputtert werden oder als Plasmanitrid aufgebracht werden.

Bei einem Halbleiterplättchen nach Fig. 23 bzw. nach Fig. 24 ist die Lage der Passivierungskante der Oxid- Nitrid-Doppelschicht bezüglich der Innenkante des Schutzringes 7 selbstjustiert.

Bei allen Ausführungsbeispielen kann die Fotoresistschicht 11 durch eine andere Hilfsschicht ersetzt werden, die sich für die jeweils gewählte Strukturierungstechnik eignet.

Die Anwendung der Erfindung ist vorteilhaft bei Schutzringbreiten kleiner als 2,5 μm, insbesondere bei Schutzringbreiten im Bereich von Zehntel Mikrometern.

Die einzelnen Schichten einer Schottky-Diode können auch aus anderen als den beispielsweise angegebenen Materialien bestehen. Wichtig ist, daß die Schichten je nach Verwendungszweck beispielsweise isolieren oder selektiv ätzbar sind oder andere Eigenschaften aufweisen, die bei den beispielsweise angegebenen Materialien vorhanden sind.

## Patentansprüche

1. Schottky-Kontakt auf einer Halbleiteroberfläche (3), die einen dotierten, selbstjustierend angebrachten Schutzring (7) im Randbereich des Schottky-Kontaktes aufweist, wobei Teile des Schutzringes mittels mindestens einer Schicht abgedeckt sind, und mindestens eine Schicht, die Teile des Schutzringes abdeckt, als eine in Bezug auf den äußeren Rand des Schutzrings (7) selbstjustierende Schicht (5; 21, 22; 33, 34) angebracht sind, dadurch gekennzeichnet, daß als eine in Bezug auf den äußeren Rand des Schutzrings (7) selbstjustierende Schutzschicht für den Schutzring (7) eine Oxid-Nitrid-Doppelschicht (21, 22) vorgesehen ist.

2. Schottky-Kontakt nach Anspruch 1, dadurch gekennzeichnet, daß die Passivierungskante der Oxid-Nitrid-Doppelschicht (21, 22) mit der Innenkante des Schutzringes (7) zusammenfällt.

3. Schottky-Kontakt nach Anspruch 1 oder 2, dadurch gekennzeichnet, daß die Schutzringbreite kleiner als 0,5 μm ist.

4. Schottky-Kontakt nach einem der Ansprüche 1 bis 3, dadurch gekennzeichnet, daß die Oxidschicht (21) aus Siliziumdioxid besteht.

5. Schottky-Kontakt nach einem der Ansprüche 1 bis 4, dadurch gekennzeichnet, daß die Nitridschicht (22) aus Siliziumnitrid besteht.

6. Schottky-Kontakt nach Anspruch 1, dadurch gekennzeichnet, daß Teile des Schutzringes des Schottky-Kontaktes mittels mindestens zweier Schichten, einer ersten Schicht (4) und einer über der ersten Schicht (4) angebrachten zweiten Schicht (5) abgedeckt sind, die aus unterschiedlichen, selektiv ätzbaren, elektrisch isolierenden Materialien bestehen und daß die zweite Schicht (5) alle Kanten der ersten Schicht (4) hermetisch dicht abdeckt und zusätzlich mindestens einen Teil der Schutzringoberfläche abdeckt, der an die erste Schicht (4) angrenzt, und daß die zweite Schicht (5) als Sperre gegen Verunreinigungen dient.

7. Schottky-Kontakt nach Anspruch 6, dadurch gekennzeichnet, daß die erste Schicht (4) aus Siliziumdioxid und die zweite Schicht (5) aus Siliziumnitrid besteht.

8. Schottky-Kontakt auf einer Halbleiteroberfläche (3), die einen dotierten, selbstjustierend angebrachten Schutzring (7) im Randbereich des Schottky-Kontaktes aufweist, wobei Teile des Schutzringes mittels mindestens einer Schicht abgedeckt sind, und mindestens eine Schicht, die Teile des Schutzringes abdeckt, als eine in Bezug auf den äußeren Rand des Schutzringes (7) selbstjustierende Schicht (5; 21, 22; 32; 33, 34) angebracht ist, dadurch gekennzeichnet, daß als eine in Bezug auf den äußeren Rand des Schutzrings (7) selbstjustierende Schutzschicht für den Schutzring (7) mindestens eine Oxidschicht (32, 34) verwendet ist, die gleichzeitig auch noch eine an den Randbereich des Schottky-Kontaktes angrenzende Isolierschicht (4) wenigstens im Bereich der Schottky-Metallisierung abdeckt.

9. Schottky-Kontakt nach Anspruch 8, dadurch gekennzeichnet, daß für die Schutzschicht für den Schutzring (7) zusätzlich mindestens eine Nitridschicht (33) verwendet ist.

10. Schottky-Kontakt nach einem der Ansprüche 1 bis 9, dadurch gekennzeichnet, daß als Halbleitermaterialien mindestens eines der folgenden Materialien verwendet wird: Silizium, Galliumarsenid, Indiumphosphid, Germanium.

11. Schottky-Kontakt nach einem der Ansprüche 1 bis 10, dadurch gekennzeichnet, daß als Schottky-Kontakt mindestens eine Schottky-Kontakt-Schicht aus mindestens einem der Materialien Titan, Molybdän, Platin, Palladium, Nickel direkt auf der Halbleiteroberfläche (3) angebracht ist.

12. Schottky-Kontakt nach Anspruch 11, dadurch gekennzeichnet, daß die Schottky-Kontakt-Schicht mit einer oder mehreren Metallschichten verstärkt ist.

13. Schottky-Kontakt nach Anspruch 11, dadurch gekennzeichnet, daß die Schottky-Kontakt-Schicht mit einer Schichtenfolge aus Platin und Gold verstärkt ist.

14. Verfahren zur Herstellung eines Schottky-Kontaktes auf einer Halbleiteroberfläche, der einen dotierten, selbstjustierend angebrachten Schutzring (7) im Randbereich des Schottky-Kontaktes aufweist, und bei dem Teile des Schutzringes mittels mindestens einer ersten Schicht (4) abgedeckt sind, wobei zunächst die erste Schicht (4) auf der Halbleiteroberfläche (3) oder auf Teilen der Halbleiteroberfläche (3) in strukturierter Weise erzeugt wird, dadurch gekennzeichnet, daß anschließend eine zweite Schicht (5) ganzflächig abgeschieden wird, wobei die erste und die zweite Schicht aus unterschiedlichen, selektiv ätzbaren elektrisch isolierenden Materialien bestehen, daß eine Schutzringdotierung erfolgt, daß ein Fenster (8) in die zweite Schicht (5) im Bereich innerhalb des Schutzringes (7) eingebracht wird, daß durch dieses Fenster (8) selektiv zunächst der darunterliegende Teil der ersten Schicht (4, 21 bzw. LOCOS-Schicht) vollständig weggeätzt wird, daß anschließend diejenigen Teile der zweiten Schicht (5) weggeätzt werden, die sich oberhalb des weggeätzten Teiles der ersten Schicht (4, 21 bzw. LOCOS-Schicht) befinden, daß anschließend weitere Verfahrensschritte erfolgen können und daß schließlich ein Schottky-Kontakt angebracht wird.

15. Verfahren nach Anspruch 14, dadurch gekennzeichnet, daß die zweite Schicht (5) eine solche Dicke aufweist, daß die Dotierung des Schutzringes (7) durch die zweite Schicht (5) hindurch möglich ist.

16. Verfahren zur Herstellung eines Schottky-Kontaktes auf einer Halbleiteroberfläche (3), bei dem im Randbereich des Schottky-Kontaktes ein dotierter Schutzring (7) selbstjustierend angebracht wird und bei dem Teile des Schutzringes mittels mindestens einer Schicht abgedeckt werden, dadurch gekennzeichnet, daß auf die Halbleiteroberfläche (3) als Schutzschicht für den Schutzring (7) eine Oxid-Nitrid-Doppelschicht (21, 22) aufgebracht wird, daß auf diese Oxid-Nitrid-Doppelschicht eine Oxidschicht (4) und sodann eine erste Hilfsschicht (11) zur Strukturierung der Oxidschicht (4) aufgebracht wird, daß die Oxidschicht (4) mittels Oxidätzung mit Unterätzung strukturiert wird, daß zur Maskierung des Schutzringbereiches (6) eine zweite Hilfsschicht (12) aufgebracht wird, daß die erste Hilfsschicht (11) abgehoben wird, daß die Dotierung des Schutzringbereiches (6) durch die noch freiliegenden Bereiche der Oxid-Nitrid-Doppelschicht (21, 22) hindurch erfolgt, daß eine weitere Oxidschicht (23) als Ätzmaske für die Oxid-Nitrid-Doppelschicht (21, 22) aufgebracht wird, daß die zweite Hilfsschicht (12) abgehoben wird, daß die Oxid-Nitrid-Doppelschicht (21, 22) im Inneren des Schutzringes (7) weggeätzt wird und daß schließlich ein Schottky-Metall (17) angebracht wird.

17. Verfahren nach Anspruch 16, dadurch gekennzeichnet, daß als erste Hilfsschicht (11) ein Fotoresist aufgebracht wird.

18. Verfahren nach Anspruch 16 oder 17, dadurch gekennzeichnet, daß als zweite Hilfsschicht (12) eine Metallschicht aufgebracht wird.

19. Verfahren nach einem der Ansprüche 16 bis 18, dadurch gekennzeichnet, daß nach Aufbringen der weiteren Oxidschicht (23) eine Nitridschicht (5) aufgebracht wird.

20. Verfahren nach einem der Ansprüche 17 bis 19, dadurch gekennzeichnet, daß auf die Nitridschicht (5) eine zusätzliche Oxidschicht (16) aufgebracht wird.

21. Verfahren zur Herstellung eines Schottky-Kontaktes auf einer Halbleiteroberfläche (3), der einen dotierten, selbstjustierend angebrachten Schutzring (7) im Randbereich des Schottky-Kontaktes aufweist und bei dem Teile mittels mindestens einer ersten Schicht abgedeckt werden, wobei zunächst die erste Schicht (4) auf der Halbleiteroberfläche (3) oder auf Teilen der Halbleiteroberfläche (3) erzeugt wird, auf diese erste Schicht (4) eine erste Hilfsschicht (11) zur Strukturierung der ersten Schicht (4) aufgebracht wird, die erste Schicht (4) mittels Ätzung strukturiert wird, zur Maskierung des Schutzringbereiches (6) eine zweite Hilfsschicht (12) aufgebracht wird, die erste Hilfsschicht (11) abgehoben wird, und die Dotierung des Schutzringes (7) erfolgt, dadurch gekennzeichnet, daß mindestens eine weitere Schicht (5; 16; 32; 33, 34) selbstjustierend aufgebracht wird, daß die zweite Hilfsschicht (12) abgehoben wird, daß anschließend weitere Verfahrensschritte erfolgen, und daß schließlich ein Schottky-Kontakt (17) angebracht wird.

22. Verfahren nach Anspruch 21, dadurch gekennzeichnet, daß als erste Hilfsschicht (11) ein Fotoresist verwendet wird.

23. Verfahren nach Anspruch 21, oder 22, dadurch gekennzeichnet, daß als zweite Hilfsschicht (12) ein Metall verwendet wird.

24. Verfahren nach Anspruch 23, dadurch gekennzeichnet, daß auf das Metall der zweiten Hilfsschicht (12) ein weiteres Metall (31) aufgedampft wird.

25. Verfahren nach Anspruch 24, dadurch gekennzeichnet, daß als Metall für die zweite Hilfsschicht (12) Titan verwendet wird und daß auf dieses Titan Palladium aufgedampft wird.

26. Verfahren nach einem der Ansprüche 21 bis 25, dadurch gekennzeichnet, daß für eine der selbstjustierend aufgebrachten weiteren Schichten (32, 34) eine Oxidschicht verwendet wird.

27. Verfahren nach einem der Ansprüche 21 bis 26, dadurch gekennzeichnet, daß für mindestens eine der selbstjustierend aufgebrachten weiteren Schichten (33) eine Nitridschicht verwendet wird.

## Claims

1. Schottky contact on a semiconductor surface (3) which exhibits a doped guard ring (7), which is applied in a self-adjusting manner, in the edge region of the Schottky contact, parts of the guard ring being covered by means of at least one layer, and at least one layer which covers parts of the guard ring being applied as a layer (5; 21, 22; 33, 34) which is self-adjusting with respect to the outer edge of the guard ring (7), characterized in that an oxide-nitride double layer (21, 22) is provided as a protective layer for the guard ring (7), which protective layer is self-adjusting with respect to the outer edge of the guard ring (7).

2. Schottky contact according to Claim 1, characterized in that the passivation edge of the oxide-nitride double layer (21, 22) coincides with the inner edge of the guard ring (7).

3. Schottky contact according to Claim 1 or 2, characterized in that the guard ring width is less than 0.5 μm.

4. Schottky contact according to one of Claims 1 to 3, characterized in that the oxide layer (21) consists of silicon dioxide.

5. Schottky contact according to one of Claims 1 to 4, characterized in that the nitride layer (22) consists of silicon nitride.

6. Schottky contact according to Claim 1, characterized in that parts of the guard ring of the Schottky contact are covered by means of at least two layers, a first layer (4) and a second layer (5) which is applied above the first layer (4), which consist of different selectively etchable electrically insulating materials and that the second layer (5) hermetically sealingly covers all edges of the first layer (4) and additionally covers at least a part of the guard ring surface which adjoins the first layer (4), and that the second layer (5) serves as a barrier against contamination.

7. Schottky contact according to Claim 6, characterized in that the first layer (4) consists of silicon dioxide and the second layer (5) consists of silicon nitride.

8. Schottky contact on a semiconductor surface (3) which exhibits a doped guard ring (7), which is applied in a self-adjusting manner in the edge region of the Schottky contact, parts of the guard ring being covered by means of at least one layer and at least one layer, which covers parts of the guard ring, being applied as a layer (5; 21, 22; 32; 33, 34) which is self-adjusting with respect to the outer edge of the guard ring (7), characterized in that, as a protective layer for the guard ring (7), which is self-adjusting with respect to the outer edge of the guard ring (7), at least one oxide layer (32, 34) is used which, at the same time, also covers an insulating layer (4) adjoining the edge region of the Schottky contact, at least in the region of the Schottky metallization.

9. Schottky contact according to Claim 8, characterized in that at least one nitride layer (33) is additionally used for the protective layer for the guard ring (7).

10. Schottky contact according to one of Claims 1 to 9, characterized in that at least one of the following materials is used as semiconductor materials: silicon, gallium arsenide, indium phosphide, germanium.

11. Schottky contact according to one of Claims 1 to 10, characterized in that at least one Schottky contact layer of at least one of the materials titanium, molybdenum, platinum, palladium, nickel is directly applied to the semiconductor surface (3) as Schottky contact.

12. Schottky contact according to Claim 11, characterized in that the Schottky contact layer is reinforced with one or more metal layers.

13. Schottky contact according to Claim 11, characterized in that the Schottky contact layer is reinforced with a sequence of layers of platinum and gold.

14. Method for producing a Schottky contact on a semiconductor surface which exhibits a doped guard ring (7) which is applied in a self-adjusting manner in the edge region of the Schottky contact and in which parts of the guard ring are covered by means of at least one first layer (4), the first layer (4) initially being created in a structured manner on the semiconductor surface (3) or on parts of the semiconductor surface (3), characterized in that subsequently a second layer (5) is deposited on the entire area, the first and the second layer consisting of different, selectively etchable electrically insulating materials, that a guard ring doping is effected, that a window (8) is opened in the second layer (5) in the region within the guard ring (7), that initially the underlying part of the first layer (4, 21 or LOCOS layer) is selectively completely etched away through this window (8), that subsequently the parts of the second layer (5) located above the etched-away part of the first layer (4, 21 or LOCOS layer) are etched away, that subsequently further method steps can occur and that finally a Schottky contact is applied.

15. Method according to Claim 14, characterized in that the second layer (5) exhibits such a thickness that the doping of the guard ring (7) is possible through the second layer (5).

16. Method for producing a Schottky contact on a semiconductor surface (3), in which a doped guard ring (7) is applied in a self-adjusting manner in the edge region of the Schottky contact and in which parts of the guard ring are covered by means of at least one layer, characterized in that an oxide-nitride double layer (21, 22) is applied to the semiconductor surface (3) as protective layer for the guard ring (7), that an oxide layer (4) and then a first auxiliary layer (11) for structuring the oxide layer (4) is applied to this oxide-nitride double layer, that the oxide layer (4) is structured by means of oxide etching with underetching, that a second auxiliary layer (12) is applied for masking the guard ring region (6), that the first auxiliary layer (11) is lifted away, that the guard ring region (6) is doped through the regions of the oxide-nitride double layer (21, 22) which are still exposed, that a further oxide layer (23) is applied as etching mask for the oxide-nitride double layer (21, 22), that the second auxiliary layer (12) is lifted away, that the oxide-nitride double layer (21, 22) is etched away on the inside of the guard ring (7), and that, finally, a Schottky metal (17) is applied.

17. Method according to Claim 16, characterized in that a photoresist is applied as first auxiliary layer (11).

18. Method according to Claim 16 or 17, characterized in that a metal layer is applied as second auxiliary layer (12).

19. Method according to one of Claims 16 to 18, characterized in that a nitride layer (5) is applied after the further oxide layer (23) has been applied.

20. Method according to one of Claims 17 to 19, characterized in that an additional oxide layer (16) is applied to the nitride layer (5).

21. Method for producing a Schottky contact on a semiconductor surface (3) which exhibits a doped guard ring (7) which is applied in a self-adjusting manner in the edge region of the Schottky contact and in which parts are covered by means of at least one first layer, the first layer (4) initially being created on the semiconductor surface (3) or on parts of the semiconductor surface (3), a first auxiliary layer (11) being applied to this first layer (4) for structuring the first layer (4), the first layer (4) being structured by means of etching, a second auxiliary layer (12) being applied for masking the guard ring region (6), the first auxiliary layer (11) being lifted away and the guard ring (7) being doped, characterized in that at least one further layer (5; 16; 32; 33, 34) is applied in a self-adjusting manner, that the second auxiliary layer (12) is lifted away, that subsequently further method steps occur and that, finally, a Schottky contact (17) is applied.

22. Method according to Claim 21, characterized in that a photoresist is used as first auxiliary layer (11).

23. Method according to Claim 21 or 22, characterized in that a metal is used as second auxiliary layer (12).

24. Method according to Claim 23, characterized in that a further metal (31) is vapour-deposited on the metal of the second auxiliary layer (12).

25. Method according to Claim 24, characterized in that titanium is used as metal for the second auxiliary layer (12) and that palladium is vapour-deposited on this titanium.

26. Method according to one of Claims 21 to 25, characterized in that an oxide layer is used for one of the further layers (32, 34) which are applied in a self-adjusting manner.

27. Method according to one of Claims 21 to 26, characterized in that a nitride layer is used for at least one of the further layers (33) which are applied in a self-adjusting manner.

**Revendications**

1. Contact Schottky disposé sur la surface (3) d'un semiconducteur, qui comporte, dans la zone marginale du contact Schottky, un anneau de protection dopé (7), déposé d'une manière alignée, et dans lequel des parties de l'anneau de protection sont recouvertes par au moins une couche, et au moins une couche, qui recouvre l'anneau de protection, est disposée sous la forme d'une couche (5; 21, 22; 33, 34) auto-alignée par rapport au bord extérieur de l'anneau de protection (7), caractérisé par le fait qu'il est prévu, pour l'anneau de protection (7) , comme couche de protection auto-alignée par rapport au bord extérieur de cet anneau, une couche double d'oxyde et de nitrure (21, 22).

2. Contact Schottky suivant la revendication 1, caractérisé par le fait que le bord de passivation de la couche double d'oxyde et de nitrure (21, 22) coïncide avec le bord intérieur de l'anneau de protection (7).

3. Contact Schottky suivant la revendication 1 ou 2, caractérisé par le fait que la largeur de l'anneau de protection est inférieure à 0,5 μm.

4. Contact Schottky suivant l'une des revendications 1 à 3, caractérisé par le fait que la couche d'oxyde (21) est constituée par du bioxyde de silicium.

5. Contact Schottky suivant l'une des revendications 1 à 4, caractérisé par le fait que la couche de nitrure (22) est constituée par du nitrure de silicium.

6. Contact Schottky suivant la revendication 1, caractérisé par le fait que des parties de l'anneau de protection du contact Schottky sont recouvertes par au moins deux couches, à savoir une première couche (4) et une seconde couche (5) disposée au-dessus de la première couche (4), ces couches étant constituées par des matériaux électriquement isolants, différents, pouvant être corrodés de façon sélective, et que la seconde couche (5) recouvre d'une manière absolument étanche la totalité des bords de la première couche (4) et recouvre en outre au moins une partie de la surface de l'anneau de protection, qui jouxte la première couche (4), et que la seconde couche (5) est utilisée comme barrière contre des impuretés.

7. Contact Schottky suivant la revendication 6, caractérisé par le fait que la première couche (4) est constituée par du bioxyde de silicium et que la seconde couche (5) est constituée par du nitrure de silicium.

8. Contact Schottky disposé sur la surface (3) d'un semiconducteur, qui comporte, dans la zone marginale du contact Schottky, un anneau de protection dopé (7), déposé d'une manière alignée, et dans lequel les parties de l'anneau de protection sont recouvertes par au moins une couche, et au moins une couche, qui recouvre l'anneau de protection, est disposée sous la forme d'une couche (5; 21, 22; 33, 34) auto-alignée par rapport au bord extérieur de protection (7), caractérisé par le fait qu'on utilise, pour l'anneau de protection (7), comme couche de protection auto-alignée par rapport au bord extérieur de cet anneau, au moins une couche d'oxyde (32, 34), qui recouvre, au moins dans la zone de la métallisation Schottky, une couche isolante (4) jouxtant la zone marginale du contact Schottky.

9. Contact Schottky suivant la revendication 8, caractérisé par le fait qu'on utilise en supplément au moins une couche de nitrure (33) comme couche de protection pour l'anneau de protection (7).

10. Contact Schottky suivant l'une des revendications 1 à 9, caractérisé par le fait qu'on utilise comme matériaux semiconducteurs au moins l'un des matériaux suivants: silicium, arseniure de gallium, phosphure d'indium, germanium.

11. Contact Schottky suivant l'une des revendications 1 à 10, caractérisé par le fait qu'on dépose, en tant que contact Schottky, au moins une couche de contact Schottky constituée par au moins l'un des matériaux: titane, molybdène, platine, palladium, nickel, directement sur la surface (3) du semiconducteur.

12. Contact Schottky suivant la revendication 11, caractérisé par le fait que la couche de contact Schottky est renforcée par une ou plusieurs couches métalliques.

13. Contact Schottky suivant la revendication 11, caractérisé par le fait que la couche de contact Schottky est renforcée par une succession de couches de platine et d'or.

14. Procédé pour fabriquer un contact Schottky sur une surface d'un semiconducteur, qui comporte, dans la zone marginale du contact Schottky, une bague de protection dopée (7), qui est disposée en étant auto-alignée, et selon lequel des parties de l'anneau de protection sont recouvertes par au moins une première couche (4), la première couche (4) étant formée en premier, d'une manière structurée, sur la surface (3) du semiconducteur ou sur des parties de cette surface, caractérisé par le fait qu'on dépose ensuite, sur toute la surface, une seconde couche (5), les première et seconde couches étant constituées par des matériaux électriquement isolants, différents, pouvant être corrodés de façon sélective, qu'on réalise ensuite un dopage de l'anneau de protection, qu'on aménage une fenêtre (8) dans la seconde couche (5) dans la zone située à l'intérieur de l'anneau de protection (7), que tout d'abord, à travers cette fenêtre (8), on élimine complètement et de façon sélective par corrosion la partie sous-jacente de la première couche (4, 21 et couche LOCOS), qu'ensuite on élimine par corrosion les parties de la seconde couche (5), qui sont situées au-dessus de la partie éliminée par corrosion de la première couche (4, 21 ou couche LOCOS), qu'on met ensuite en oeuvre d'autres étapes opératoires et qu'on dépose finalement un contact Schottky.

15. Procédé suivant la revendication 14, caractérisé par le fait que la seconde couche (5) possède une épaisseur telle que le dopage de l'anneau de protection (7) est possible à travers la seconde couche (5).

16. Procédé pour fabriquer un contact Schottky sur une surface (3) d'un semiconducteur, selon lequel on dépose d'une manière auto-alignée un anneau de protection dopé (7), dans la zone marginale du contact Schottky, et on recouvre des parties de l'anneau de protection à l'aide d'au moins une couche, caractérisé par le fait que sur les surfaces (3) du semiconducteur, on dépose, comme couche de protection pour l'anneau de protection (7), une couche double d'oxyde et de nitrure (21, 22), qu'on dépose sur cette couche double d'oxyde et de nitrure une couche d'oxyde (4) et ensuite une première couche auxiliaire (11) pour structurer la couche d'oxyde (4), qu'on structure la couche d'oxyde (4) en corrodant l'oxyde avec une corrosion sous-jacente, qu'on dépose une seconde couche auxiliaire (12) pour masquer la zone (6) de l'anneau de protection, qu'on élimine la première couche auxiliaire (11), qu'on réalise le dopage de la zone (6) de l'anneau de protection à travers les zones encore à nu de la couche double d'oxyde et de nitrure (21, 22), qu'on dépose une autre couche d'oxyde (23) en tant que masque contre la corrosion pour la couche double d'oxyde et de nitrure (21, 22), qu'on élimine la seconde couche auxiliaire (12), qu'on élimine par corrosion la double couche d'oxyde et de nitrure (21, 22) à l'intérieur de l'anneau de protection (16) et qu'on dépose finalement un métal Schottky (17).

17. Procédé selon la revendication 16, caractérisé par le fait qu'on dépose une résine photosensible comme première couche auxiliaire (11).

18. Procédé suivant la revendication 16 ou 17, caractérisé par le fait qu'on dépose une couche métallique comme seconde couche auxiliaire (12).

19. Procédé suivant l'une des revendications 16 à 18, caractérisé par le fait qu'après le dépôt de l'autre couche d'oxyde (23), on dépose une couche de nitrure (5).

20. Procédé suivant l'une des revendications 17 à 19, caractérisé par le fait que sur la couche de nitrure (5) on dépose une couche supplémentaire d'oxyde (16).

21. Procédé pour fabriquer un contact Schottky sur une surface (3) d'un semiconducteur, qui comporte un anneau de protection dopé (7), déposé d'une manière auto-alignée, dans la zone marginale du contact Schottky et selon lequel on recouvre des parties à l'aide d'au moins une première couche, auquel cas on forme tout d'abord la première couche (4) sur la surface (3) du semiconducteur ou sur les parties de cette surface, on dépose sur cette première couche (4) une première couche auxiliaire (11) servant à structurer la première couche (4), on structure cette couche (4) au moyen d'une corrosion, on dépose une seconde couche auxiliaire (12) pour réaliser le masquage de la zone (6) de l'anneau de protection, on élimine la première couche auxiliaire (11) et on réalise le dopage de l'anneau de protection (7), caractérisé par le fait qu'on dépose d'une manière auto-alignée au moins une autre couche (5; 16; 32; 33, 34), qu'on élimine la seconde couche auxiliaire (12), qu'on met ensuite en oeuvre d'autres étapes opératoires et qu'on dépose finalement un contact Schottky (17).

22. Procédé suivant la revendication 21, caractérisé par le fait qu'on utilise une résine photosensible comme première couche auxiliaire (11).

23. Procédé suivant la revendication 21 ou 22, caractérisé par le fait qu'on utilise un métal comme seconde couche auxiliaire (12).

24. Procédé suivant la revendication 23, caractérisé par le fait qu'on dépose par évaporation un métal supplémentaire (32) sur le métal de la seconde couche auxiliaire (12).

25. Procédé suivant la revendication 24, caractérisé par le fait qu'on utilise du titane comme métal pour la seconde couche auxiliaire (12) et qu'on dépose par évaporation du palladium sur ce titane.

26. Procédé suivant l'une des revendications 21 à 25, caractérisé par le fait qu'on utilise une couche d'oxyde pour l'une des autres couches (32, 34) déposée d'une manière auto-alignée.

27. Procédé suivant l'une des revendications 21 à 26, caractérisé par le fait qu'on utilise une couche de nitrure pour au moins l'une des autres couches (33) déposée d'une manière auto-alignée.

# FIG 1

# FIG 2

# FIG 3

# FIG 4

# FIG 5

EP 0 182 088 B1

## FIG 6

## FIG 7

## FIG 8

## FIG 9

## FIG 10

## FIG 11

## FIG 12

## FIG 13

## FIG 14

## FIG 15

## FIG 16

## FIG 17

## FIG 18

## FIG 19

## FIG 20

## FIG 21

## FIG 22

## FIG 23

## FIG 24

# FIG 25

# FIG 26

# FIG 27

# FIG 28

## FIG 29

## FIG 30